# EUROPEAN PATENT SPECIFICATION

(11) **EP 2 485 255 B1**
(45) Date of publication and mention of the grant of the patent: **28.08.2013**
(21) Application number: 11000883.6
(22) Date of filing: 04.02.2011
(51) Int. Cl.: H01L 23/367, H01L 23/373, H01L 23/40

(54) **Laminated heat sink having enhanced heat dissipation capacity**
Laminierung eines Kühlkörpers mit erweiterter Wärmeverstärkungskapazität
Dissipateur de chaleur à stratification doté d'une capacité de dissipation de chaleur améliorée

(43) Date of publication of application: 08.08.2012
(73) Proprietor: Green Energy Material Technology Ltd., Taipei Hsien (TW)
(72) Inventor: Chin, Hua-Chun, Taipei Hsien (TW); Lin, Hung-Yuan, Taipei City (TW); Teng, Fu-Wi, Taoyuan Hsien (TW)
(74) Representative: Patentanwälte Hosenthien-Held und Dr. Held

(56) References cited:
- EP-A1- 1 434 266
- EP-A2- 1 392 088
- DE-A1- 2 223 210
- DE-A1-102007 061 599
- US-A- 5 969 949
- US-A1- 2003 102 553
- US-A1- 2004 118 579
- US-A1- 2008 079 145
- US-A1- 2009 168 364
- O'CONNOR M ET AL: "Power surface mount components for high reliability applications", 19900311; 19900311 - 19900316, 11 March 1990 (1990-03-11), pages 438-443, XP010004801,

## Description

The present invention relates to a heat sink and, more particularly, to a heat sink for an electronic device, such as the CPU (central processing 5unit), LED (light emitting diode), IC (integrated circuit), rectifier, resistor, capacitor, inductor, and the like.

An electronic device or element, such as the CPU (central processing unit), LED (light emitting diode), IC (integrated circuit), rectifier, resistor, capacitor, inductor, and the like, is a heat source which easily produces a high temperature during operation, so that it is necessary to provide a heat sink to carry away the greater heat produced by the heat source so as to achieve a heat dissipation effect and to enhance the lifetime and working efficiency of the heat source. A conventional heat sink generally comprises a heatsink element, such as a metallic heatsink fin, a heat conductive tube, a chill enabling chip, a heat dissipation board, a cooling fan or the like, so as to achieve a heat dissipation effect. However, the conventional heat sink cannot dissipate the heat from the heat source exactly and quickly, thereby greatly decreasing the heat dissipation efficiency. In addition, the conventional heat sink has a very complicated construction, thereby increasing the costs of fabrication. A first prior art reference was disclosed in U.S. Patent No. 5,969,949, which disclosed a heat sink device comprising a heat emitting chip 12, a slug 16, a heat sink 21, and a plurality of screws 31. The slug 16 is made of metallic material and has a plurality of tapped holes 19. The heat sink 21 has a base 22 and a plurality of fins 23. The base 22 has a plurality of holes 28. The screws 31 are fitted through the holes 28 of the base 22 and are screwed into the tapped holes 19 of the slug 16 to detachably secure the heat sink 21 to the slug 16. Each of the screws 31 does not contact with the heat emitting chip 12. A second prior art reference was disclosed in the European Patent No. 1-434-266, which disclosed a metal/ceramic bonding substrate comprising a semi-conductor chip 18, a metal circuit plate 12, a ceramic substrate 10, a heat sink plate (metal base plate) 14, a work-hardened layer 16, a thermal grease 24, a radiating fin 26, and a plurality of screws 22. The heat sink plate (metal base plate) 14, the work-hardened layer 16 and the radiating fin 26 are combined by the screws 22. Each of the screws 22 has two ends protruding outward from the heat sink plate (metal base plate) 14 and the radiating fin 26 respectively.

The present invention relates to a heat sink according to claim 1.

The primary objective of the present invention is to provide a heat sink having an enhanced heat dissipation capacity to dissipate a heat from a heat source quickly.

According to the primary advantage of the present invention, each of the fixing bars is extended through the first heatsink plate and the second heatsink plate so that the heat produced by the heat source is directly introduced by the fixing bars and is transferred through the first heatsink plate and the second heatsink plate easily and quickly so as to achieve a quick heat dissipation effect.

According to another advantage of the present invention, each of the fixing bars can function as an electrode.

According to a further advantage of the present invention, the heat conducting bars transfer the heat produced by the heat source to the first heatsink plate and the second heatsink plate quickly so as to achieve a quick heat dissipation effect.

Further benefits and advantages of the present invention will become apparent after a careful reading of the detailed description with appropriate reference to the accompanying drawings.

In the drawings:
Fig. 1 is a front cross-sectional view of a heat sink in accordance with the preferred embodiment of the present invention.
Fig. 2 is a front cross-sectional view of a heat sink in accordance 20with another preferred embodiment of the present invention.
Fig. 3 is a front cross-sectional view of a heat sink in accordance with another preferred embodiment of the present invention.
Fig. 4 is a front cross-sectional view of a heat sink in accordance with another preferred embodiment of the present invention.
Fig. 5 is a front cross-sectional view of a heat sink in accordance with another preferred embodiment of the present invention.
Fig. 6 is a front cross-sectional view of a heat sink in accordance with another preferred embodiment of the present invention.

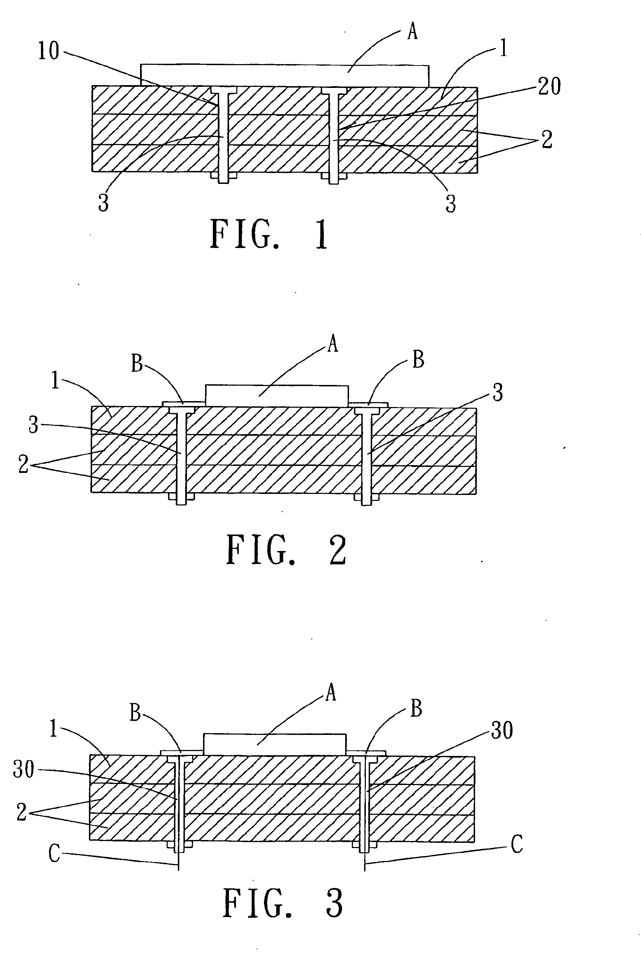

Referring to the drawings and initially to Fig. 1, a laminating heat sink in accordance with the preferred embodiment of the present invention comprises a first heatsink plate 1, at least one second heatsink plate 2 overlapping the first heatsink plate 1, and a plurality of fixing bars 3 each extended through the first heatsink plate 1 and the second heatsink plate 2 to combine and fix the first heatsink plate 1 and the second heatsink plate 2. Preferably, the laminated heat sink comprises a plurality of second heatsink plates 2 laminated each other.

The first heatsink plate 1 is made of a non-metallic material having great heatsink feature. Preferably, the first heatsink plate 1 has a porous structure. The first heatsink plate 1 has a first side adapted for being attached to heat source "A" (such as an LED and the like) and a second side abutting the second heatsink plate 2. The first heatsink plate 1 has a surface provided with a plurality of first through holes 10 to allow passage of the fixing bars 3.

The second heatsink plate 2 is made of a non-metallic material having great heatsink feature. Preferably, the second heatsink plate 2 has a porous structure. The second heatsink plate 2 has a surface provided with a plurality of second through holes 20 to allow passage of the fixing bars 3.

In the preferred embodiment of the present invention, each of the first heatsink plate 1 and the second heatsink plate 2 is made of non-metallic powder having greater heat conductivity, such as Al₂O₃, Zr₂O, AlN, SiN, BN, WC, SiC, C (graphite), crystalline SiC, ReSiC (re-crystalline SiC) and the like. Preferably, the non-metallic powder is A1N or SiC.

Each of the fixing bars 3 is made of metallic material having great heat conductivity. Preferably, each of the fixing bars 3 is a bolt, rivet, pin and the like. Each of the fixing bars 3 is perpendicular to the first heatsink plate 1 and the second heatsink plate 2. Each of the fixing bars 3 is extended through the first through holes 10 of the first heatsink plate 1 and the second through holes 20 of the second heatsink plate 2.

When in use, the heat produced by the heat source "A" is transferred to and conducted by the first heatsink plate 1 and the second heatsink plate 2 so that the first heatsink plate 1 and the second heatsink plate 2 can carry away the heat produced by the heat source "A" so as to dissipate the heat. In such a manner, each of the fixing bars 3 is extended through the first heatsink plate 1 and the second heatsink plate 2 so that the heat produced 20by the heat source "A" is directly introduced by the fixing bars 3 and is transferred through the first heatsink plate 1 and the second heatsink plate 2 easily and quickly so as to achieve a quick heat dissipation effect.

Referring to Fig. 2, each of the fixing bars 3 has a first end and a second end. The first end of each of the fixing bars 3 is electrically connected with an electrical connecting terminal "B", and the second end of each of the fixing bars 3 is electrically connected with an external power supply. The 5electrical connecting terminal "B" is connected with the heat source "A" and is located outside of the first heatsink plate 1.

Referring to Fig. 3, each of the fixing bars 3 has a hollow structure and has an inner portion provided with a passage 30 to allow passage of a conducting wire "C". The conducting wire "C" has a first end and a second end. The first end of the conducting wire "C" is electrically connected with the electrical connecting terminal "B", and the second end of the conducting wire "C" is electrically connected with the external power supply. Thus, each of the fixing bars 3 functions as an electrode.

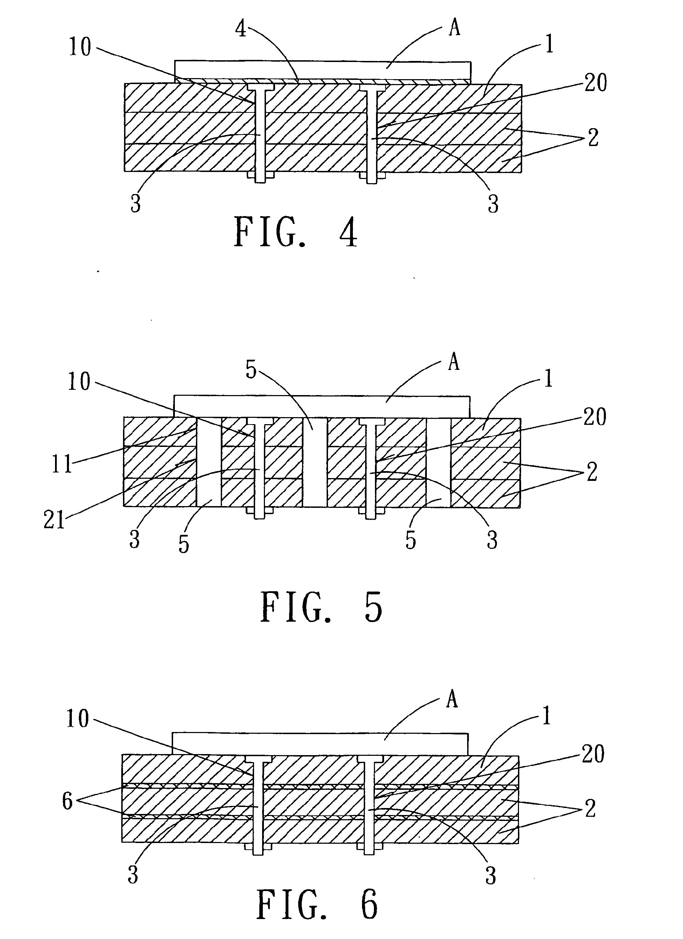

Referring to Fig. 4, the laminated heat sink further comprises a heat conducting layer 4 mounted between the heat source "A" and the first heatsink plate 1 to transfer the heat produced by the heat source "A" to the first heatsink plate 1 and the second heatsink plate 2 quickly so as to achieve a quick heat dissipation effect. In the preferred embodiment of the present invention, the heat conducting layer 4 is made of a metallic material having 20great heat conductivity, such as gold, silver, copper, iron, aluminum, cobalt, nickel, zinc, titanium, manganese and the like. Preferably, the heat conducting layer 4 is directly bonded between the heat source "A" and the first heatsink plate 1 by printing or painting.

Referring to Fig. 5, the laminated heat sink further comprises a plurality of heat conducting bars 5 each extended through the first heatsink plate 1 and the second heatsink plate 2. The first heatsink plate 1 has a plurality of first heat conducting holes 11 to allow passage of the heat conducting bars 5. The second heatsink plate 2 has a plurality of second heat conducting holes 21 to allow passage of the heat conducting bars 5. Preferably, each of the heat conducting bars 5 has a hollow structure. Thus, the heat conducting bars 5 transfer the heat produced by the heat source "A" to the first heatsink plate 1 and the second heatsink plate 2 quickly so as to achieve a quick heat dissipation effect. In the preferred embodiment of the present invention, each of the heat conducting bars 5 is made of a metallic material having great heat conductivity, such as gold, silver, copper, iron, aluminum, cobalt, nickel, zinc, titanium, manganese and the like. Alternatively, each of the heat conducting bars 5 is made of a nonmetallic material which has a heat conductivity greater than that of the first heatsink plate 1 and the second heatsink plate 2.

Referring to Fig. 6, the laminating heat sink further comprises at 20least one interface layer 6 mounted between the first heatsink plate 1 and the second heatsink plate 2. The interface layer 6 is made of a metallic material having great heat conductivity, such as a low temperature solder tin and the like. Preferably, the laminating heat sink comprises a plurality of interface layers 6 mounted between the first heatsink plate 1 and one of the second heatsink plates 2 and between the other of the second heatsink plates 2.

Accordingly, each of the fixing bars 3 is extended through the first heatsink plate 1 and the second heatsink plate 2 so that the heat produced by the heat source "A" is directly introduced by the fixing bars 3 and is transferred through the first heatsink plate 1 and the second heatsink plate 2 easily and quickly so as to achieve a quick heat dissipation effect. In addition, each of the fixing bars 3 can function as an electrode. Further, the heat conducting bars 5 transfer the heat produced by the heat source "A" to the first heatsink plate 1 and the second heatsink plate 2 quickly so as to achieve a quick heat dissipation effect.

## Claims

1. A heat sink, comprising:
a first heatsink plate (1);
at least one second heatsink plate (2) overlapping the first heatsink plate; and
a plurality of fixing bars (3) each extended through the first heatsink plate and the second heatsink plate to combine and fix the first heatsink plate and the second heatsink plate;
**characterized in that**
the first heatsink plate is made of a non-metallic material
the second heatsink plate is made of a non-metallic material
each of the fixing bars is made of metallic material

2. The heat sink of claim 1, wherein
the first heatsink plate has a surface provided with a plurality of first through holes (10) to allow passage of the fixing bars;
the second heatsink plate has a surface provided with a plurality of second through holes (20) to allow passage of the fixing bars;
each of the fixing bars is extended through the first through holes of the first heatsink plate and the second through holes of the second heatsink plate;
the first heatsink plate has a first side adapted for being attached to a heat source (A) and a second side abutting the second heatsink plate;
each of the fixing bars has an end extended through each of the first through holes of the first heatsink plate and adapted for contacting with the heat source;
the end of each of the fixing bars is leveled with the first side of the first heatsink plate and is adapted for abutting the heat source.

3. The heat sink of claim 1, wherein
the first heatsink plate has a porous structure;
the second heatsink plate has a porous structure.

4. The heat sink of claim 1, wherein
the first heatsink plate has a first side adapted for being attached to a heat source (A) and a second side abutting the second heatsink plate;
the fixing bars are adapted for contacting with the heat source to thermally conduct the first heatsink plate and the second heatsink plate with the heat source through the fixing bars.

5. The heat sink of claim 1, wherein the laminating heat sink further comprises at least one interface layer (6) mounted between the first heatsink plate and the second heatsink plate.

6. The heat sink of claim 5, wherein the interface layer is made of a metallic material having great heat conductivity.

## Patentansprüche

1. Kühlkörper, aufweisend:
eine erste Kühlplatte (1);
mindestens eine zweite Kühlplatte (2), welche die erste Kühlplatte überlappt, und
eine Mehrzahl von Befestigungsstangen (3), wobei sich jede durch die erste Kühlplatte und die zweite Kühlplatte erstreckt, um die erste Kühlplatte und die zweite Kühlplatte zu kombinieren und zu fixieren;
**dadurch gekennzeichnet, dass**
die erste Kühlplatte aus einem nicht-metallischen Material gefertigt ist;
die zweite Kühlplatte aus einem nicht-metallischen Material gefertigt ist;
jede der Befestigungsstangen aus einem metallischen Material gefertigt ist.

2. Kühlkörper nach Anspruch 1, wobei
die erste Kühlplatte eine Oberfläche hat, die mit einer Mehrzahl von ersten Durchgangsöffnungen (10) versehen ist, um die Durchführung der Befestigungsstangen zu ermöglichen;
die zweite Kühlplatte eine Oberfläche hat, die mit einer Mehrzahl von zweiten Durchgangsöffnungen (20) versehen ist, um die Durchführung der Befestigungsstangen zu ermöglichen;
jede der Befestigungsstangen sich durch die ersten Durchgangsöffnungen der ersten Kühlplatte und die zweiten Durchgangsöffnungen der zweiten Kühlplatte erstreckt; die erste Kühlplatte eine erste Seite, die dazu geeignet ist, an einer Wärmequelle (A) angebracht zu sein, und eine zweite Seite hat, die an der zweiten Kühlplatte anliegt; jede der Befestigungsstangen ein Ende hat, das sich durch die ersten Durchgangsöffnungen der ersten Kühlplatte erstreckt und dazu geeignet ist, die Wärmequelle zu kontaktieren;
das Ende jeder der Befestigungsstangen in einer Ebene mit der ersten Seite der ersten Kühlplatte ausgerichtet ist und dazu geeignet ist, an der Wärmequelle anzuliegen.

3. Kühlkörper nach Anspruch 1, wobei
die erste Kühlplatte eine poröse Struktur aufweist;
die zweite Kühlplatte eine poröse Struktur aufweist.

4. Kühlkörper nach Anspruch 1, wobei
die erste Kühlplatte eine erste Seite, die zum Anbringen an einer Wärmequelle (A) geeignet ist, und eine zweite Seite aufweist, die an der zweiten Kühlplatte anliegt; die Befestigungsstangen dazu geeignet sind, mit der Wärmequelle in Kontakt zu stehen, um thermisch die erste Kühlplatte und die zweite Kühlplatte mit der Wärmequelle über die Befestigungsstangen zu verbinden.

5. Kühlkörper nach Anspruch 1, wobei der mehrschichtige Kühlkörper ferner mindestens eine Zwischenschicht (6) aufweist, die zwischen der ersten Kühlplatte und der zweiten Kühlplatte angebracht ist.

6. Kühlkörper nach Anspruch 5, wobei die Zwischenschicht aus einem metallischen Material mit großer Wärmeleitfähigkeit gefertigt ist.

## Revendications

1. Dissipateur thermique, comprenant :
une première plaque de dissipateur thermique (1) ;
au moins une deuxième plaque de dissipateur thermique (2) chevauchant la première plaque de dissipateur thermique ; et
une pluralité de barres de fixation (3) chaque barre s'étendant à travers la première plaque de dissipateur thermique et la deuxième plaque de dissipateur thermique pour associer et fixer la première plaque de dissipateur thermique et la deuxième plaque de dissipateur thermique ;
**caractérisé en ce que**
la première plaque de dissipateur thermique est composée d'une matière non-métallique
la deuxième plaque de dissipateur thermique est composée d'une matière non-métallique
chaque barre de fixation est en métal.

2. Dissipateur thermique de la revendication 1, où
la première plaque de dissipateur thermique a une surface pourvue d'une pluralité de premières perforations (10) pour permettre le passage des barres de fixation ;
la deuxième plaque de dissipateur thermique a une surface pourvue d'une pluralité de deuxièmes perforations (20) pour permettre le passage des barres de fixation ; chaque barre de fixation s'étend à travers les premières perforations de la première plaque de dissipateur thermique et les deuxièmes perforations de la deuxième plaque de dissipateur thermique ;
la première plaque de dissipateur thermique a un premier côté adapté pour être relié à la source de chaleur (A) et un second côté jouxtant la deuxième plaque de dissipateur thermique ;
chaque barre de fixation a une extrémité s'étendant à travers chacune des premières perforations de la première plaque de dissipateur thermique et est adaptée pour entrer en contact avec la source de chaleur ;
l'extrémité de chaque barre de fixation est mise au même niveau que le premier côté de la première plaque de dissipateur thermique et est adaptée pour jouxter la source de chaleur.

3. Dissipateur thermique de la revendication 1, où
la première plaque de dissipateur thermique a une structure poreuse ;
la deuxième plaque de dissipateur thermique a une structure poreuse.

4. Dissipateur thermique de la revendication 1, où
la première plaque de dissipateur thermique a un premier côté adapté pour être relié à une source chaleur (A) et un second côté jouxtant la deuxième plaque de dissipateur thermique ;
les barres de fixation sont adaptées pour entrer en contact avec la source de chaleur et conduire thermiquement la première plaque de dissipateur thermique et la deuxième plaque de dissipateur thermique à la source chaleur à travers les barres de fixation.

5. Dissipateur thermique de la revendication 1, où le revêtement du dissipateur thermique comprend en outre au moins une couche d'interface (6) montée entre la première plaque de dissipateur thermique et la deuxième plaque de dissipateur thermique.

6. Dissipateur thermique de la revendication 5, où la couche d'interface est en métal ayant une importante conductivité thermique.
